# EUROPEAN PATENT APPLICATION

(11) **EP 4 199 359 A1**
(43) Date of publication of application: **21.06.2023**
(21) Application number: 21275188.7
(22) Date of filing: 17.12.2021
(51) Int. Cl.: H03M 1/12, G02F 7/00

(54) **ANALOGUE TO DIGITAL CONVERTER**

(71) Applicant: BAE SYSTEMS plc, London SW1Y 5AD (GB)
(72) Inventor: The designation of the inventor has not yet been filed
(74) Representative: BAE SYSTEMS plc Group IP Department

(57) **Abstract**

A method of performing analogue to digital conversion of an analogue input signal. The method comprises: generating a first laser pulse train having a first wavelength; generating a second laser pulse train having a second different wavelength; modulating, using an interferometric modulator, the first laser pulse train and the second laser pulse train on the basis of the analogue input signal, wherein the interferometric modulator is configured such that its response to the first laser pulse train is not in phase with its response to the second laser pulse train; determining, on the basis of the modulated first laser pulse train and the modulated second laser pulse train, a voltage of the analogue input signal; and generating a digital signal indicative of the determined voltage.

## Description

### Technical Field

The present invention concerns an analogue-to-digital conversion system and a method of performing analogue-to-digital conversion of electrical signals.

### Background

An analogue-to-digital converter (ADC) operates to convert an analogue electrical input signal into a digital signal indicative of a voltage of the input signal. The precision of an ADC is limited (in particular when operating at high frequencies inputs) by timing jitter, amongst other factors. Timing jitter is variation in the time interval between ADC samples due to variations in the sampling clock period and in the sampling circuit. The ADC is configured to sample the analogue signal according to the clock period (for example, on a rising or falling edge of a clock pulse), and therefore timing jitter leads to variability in the time at which the analogue input signal is sampled by the ADC. If the analogue signal varies with time (which is typically the case), the timing jitter manifests itself as an error in the value of the output digital signal.

It is well known in the art that laser pulses can be made very short in time and generated at a regular repeat rate with extremely low timing jitter. An optically assisted ADC, which is also known in the art, includes an optical system comprising a laser, an interferometric modulator, and an optical to electrical detector. It will be appreciated by the skilled person that the optical system may also comprise further optical elements in addition to those set out here. The laser is configured to generate a laser pulse train comprising a series of regular laser pulses at precise time intervals. The laser pulses are modulated, on the basis of the analogue electrical input signal, using an interferometric modulator (for example, a Mach Zehnder modulator). A Mach Zehnder modulator (MZM) comprises two optical paths. The incoming optical pulse is split between the two paths and subsequently recombined. The modulator optical output is determined by the relative optical phase (i.e. due to the difference in group delay) between the two paths. In a MZM this relative phase can be modified by applying an electric field across one of the two paths. It will be appreciated by the skilled person that an electric field can also be applied to both paths, and the relative optical phase varied by varying the electric field across one or both of the paths. The electrical field is established by applying a voltage (for example, the analogue input signal) across electrodes placed close to the optical paths. An optical detector converts the optical signal output of the modulator into an electrical signal which is digitised using a conventional ADC clocked at the laser pulse rate. The optical detector may include low pass electrical filtering and may involve optical finite impulse response filtering. The ADC output samples are therefore dependent on the modulation of the laser pulse train, which is determined by the value of the analogue input signal voltage. It is therefore possible to determine the voltage of the analogue signal by evaluating the ADC output samples.

However, the output of the optical system has a periodic (for example, sinusoidal) response to the analogue input voltage. The minimum output occurs when the relative phase between the two paths is such that there is maximal destructive interference between the optical signals at the modulator output. The maximum output occurs when the relative phase between the two paths is such that there is maximal constructive interference between the optical signals at the modulator output. As the relative phase shift applied by the interferometric modulator increases, the output of the optical system alternates between constructive and destructive interference, giving a repeating periodic output. The additional applied voltage required for a 180 degree shift along the periodic response is conventionally called Vpi.

At the peaks and troughs of the periodic response, the change in the output of the modulator for a given change in the analogue input signal is reduced. Thus, such optically assisted ADCs have reduced sensitivity when operating around the peaks and troughs of the periodic response. Therefore, the operation of the interferometric modulator is typically constrained to a pseudo-linear region of the periodic response of the optical system (i.e. a region between a peak and an adjacent trough, within a single half-cycle of the periodic response). The central operating point of the modulator is controlled by adjusting the delays between the two paths using a suitable means (for example, by adding a bias voltage). However, this constraint limits the operating range of the optically assisted ADC.

Often, the operation of the interferometric modulator in such optically assisted ADCs must be further constrained to approximately one quarter of a cycle of the periodic response or less, in order to keep the system response in the approximately linear region of a modulator's sinusoidal response (i.e. to avoid operation around the peaks and troughs of the response, where the sensitivity of the output to variations in the input signal voltage is reduced).

The present invention seeks to mitigate the above-mentioned problems. Alternatively or additionally, the present invention seeks to provide an improved analogue-to-digital converter.

### Summary

The present invention provides, according to a first aspect, a method of performing analogue to digital conversion of an analogue input signal, the method comprising:
generating a first laser pulse train having a first wavelength;
generating a second laser pulse train having a second different wavelength;
modulating, using an interferometric modulator, the first laser pulse train and the second laser pulse train on the basis of the analogue input signal, wherein the interferometric modulator is configured such that its response to the first laser pulse train is not in phase with its response to the second laser pulse train;
determining, on the basis of the modulated first laser pulse train and the modulated second laser pulse train, a voltage of the analogue input signal; and generating a digital signal indicative of the determined voltage.

As discussed above, in the systems of the prior art, operation of the optical system of an optically assisted ADC beyond its pseudo-linear region is undesirable, as operation around the peaks and troughs of the periodic (for example, sinusoidal) response provides low sensitivity to changes in the input signal. However, by configuring the interferometric modulator such that its response to the first laser pulse train is not in phase with its response to the second laser pulse train, the pseudo-linear regions of those two responses are misaligned. Thus, by processing both the modulated first laser pulse train and the modulated second laser pulse train, the operating range over which the analogue-to-digital converter can provide high input sensitivity is increased. Thus, the analogue-to-digital converter of the present invention provides extended dynamic range whilst maintaining sensitivity to small signals.

It may be that the phase relationship between the interferometric modulator's responses to the first and second laser pulse trains is set by applying a bias voltage (for example, a direct current bias voltage) to a control input of the interferometric modulator (for example, the same input as that to which the analogue input signal is applied). For example, it may be that the analogue input signal is summed with the bias voltage. It may be that the interferometric modulator is configured such that its response to the first laser pulse train is substantially in quadrature with its response to the second laser pulse train. It may be that the responses are arranged in quadrature by controlling the bias voltage. It may be that the responses are arranged in quadrature by controlling one or both of the first wavelength and the second wavelength.

It may be that generating the first laser pulse train comprises generating a first plurality of laser pulses according to a first pulse repetition rate. It may be that generating the second laser pulse train comprises generating a second plurality of lasers pulses according to a second pulse repetition rate. It may be that the first pulse repetition rate is the same as the second pulse repetition rate. It may be that the first pulse train and the second pulse train are synchronised. Thus, it may be that each pulse in the first plurality of laser pulses is substantially coincident in time with a pulse in the second plurality of laser pulses.

It may be that generating the first laser pulse train comprises producing, for a first predetermined period of time, a laser having the first wavelength. It may be that the generating the first laser pulse train comprises ceasing the producing for a second predetermined period of time. It may be that generating the second laser pulse train comprises further producing, for a third predetermined of time, a laser having the second wavelength. It may be that the generating the second laser pulse train comprises ceasing the further producing for a fourth predetermined period of time. It may be that the first predetermined period of time is equal to the third predetermined period of time. It may be that the second predetermined period of time is equal to the fourth predetermined period of time. It may be that one or both of the first laser pulse train and the second laser pulse train comprises (for example, consists of) pulses having a pulse width of less than half a period of a frequency (for example, a maximum frequency) of the input signal. It may be that the pulses have a pulse width of less than a fifth of the period of the input signal. It may be that the pulses have a pulse width of less than a tenth of the period of the input signal. It may be that the pulses have a pulse width of less than a twentieth of the period of the input signal.

It may be that the modulating comprises operating the interferometric modulator such that variation of the analogue input signal gives rise to a phase shift of greater than half a cycle of the wavelengths of one or both of the first laser pulse train and the second laser pulse train. It may be that the interferometric modulator is configured to operate by applying a relative phase shift (i.e. a group delay) between two instances of the input signal (i.e. of the first laser pulse train and the second laser pulse train). It may be that the applied group delay is greater than half a period of one or both of the first wavelength and the second wavelength.

Operating the interferometric modulator to give a phase shift of greater than half a cycle of one or both of the first wavelength and the second wavelength can provide the analogue-to-digital converter of the present invention with a range of operation which extends beyond the pseudo-linear region of the periodic (for example, sinusoidal) response of the optical system. It will be appreciated by the skilled person that operating the interferometric modulator in this way would ordinarily, if only a single laser pulse train was used, result in the interferometric modulator producing the same output for two or more different voltages of the analogue input signal. Configuring the modulator such that its response to the first laser pulse train is not in phase (for example, is substantially in quadrature) with its response to the second laser pulse train and processing both the modulated first laser pulse train and the modulated second laser pulse train, allows the voltage of the analogue input signal which has given rise to the modulator output to be determined. Thus, such embodiments provide an analogue to digital converter having further increased dynamic range.

The variation may give rise to a phase shift of greater than one cycle of one or both of the wavelengths. Operating the interferometric modulator to give a phase shift of greater than a cycle of one or both of the first wavelength and the second wavelength can allow the interferometric modulator to extend the range of operation of the analogue-to-digital converter over multiple cycles of the periodic (for example, sinusoidal) response of the modulator. Thus, such embodiments provide an analogue to digital converter having yet further increased dynamic range. This functionality can be referred to as "folding" the input signal.

The variation may give rise to a phase shift of greater than two cycles of the wavelengths, preferably greater than five cycles of the wavelengths, more preferably greater than ten cycles of the wavelengths.

It may be that the modulated first laser pulse train has a first modulation state, associated with the modulation applied to the first laser pulse train. The modulated second laser pulse train may have a second modulation state, associated with the modulation applied to the second laser pulse train. In such cases, it may be that the determining comprises evaluating the first modulation state and the second modulation state.

As previously mentioned, operating the interferometric modulator to give a phase shift of greater than a cycle may result in the interferometric modulator producing the same output for two or more different voltages of the analogue input signal. Thus, it may be that at least one combination of the first modulation state and the second modulation state is associated with a plurality of voltages of the analogue input signal. In such cases, it may be that the determining comprises identifying a voltage in the plurality which has caused the first modulation state and the second modulation state.

The identifying may be performed on the basis of one or more previously determined voltages of the analogue input signal. Thus, the identifying may be performed based on prior knowledge of the input signal. The method may comprise storing (for example, in memory) one or more previously determined voltages (for example, the one or more most recently determined voltages) of the analogue input signal. The identifying may be performed on the basis of a most recently determined voltage of the analogue input signal. In such cases, the identifying may comprise identifying one of the plurality of voltages which is closest to most recently determined voltage of the analogue input signal.

The method may comprise operating an analogue-to-digital converter to convert the analogue input signal into a digitised input signal. In such cases, it may be that the identifying is performed on the basis of the digitised input signal. In such embodiments, the identifying may comprise identifying one of the plurality of voltages which is closest to the voltage indicated by the digitised input signal. It may be that the analogue-to-digital converter is clocked at the pulse repetition rate. It may be that the analogue-to-digital converter is configured such that it does not saturate for any voltages of the analogue input signal within the measurement range of the analogue to digital conversion system. It may be that, prior to input to the analogue-to-digital converter, the analogue input signal is passed through an attenuating coupler. The analogue-to-digital converter may comprise an optically assisted analogue-to-digital converter. Embodiments in which the analogue-to-digital converter comprises an optically assisted analogue-to-digital converter can provide substantially equal propagation delays at the outputs of the three analogue-to-digital converters. This can simplify the processing required to be performed by the encoder. It may be that the optically assisted analogue-to-digital converter operates using one of the first laser pulse train and the second laser pulse train.

The optical system may be configured such that its response to the first laser pulse train is not in phase with its response to the second laser pulse train. The optical system may be configured such that its response to the first laser pulse train is substantially in quadrature with its response to the second laser pulse train. The interferometric modulator may be configured such that its response to the first laser pulse train is substantially in quadrature with its response to the second laser pulse train. Configuring the optical system such that its response to the first laser pulse train is substantially in quadrature with its response to the second laser pulse train can minimise loss of sensitivity by ensuring maximal spacing apart of the points of inflection in the responses. It may be that the method comprises controlling the wavelength of one or both of the first laser pulse train and the second laser pulse train to set the phase relationship between the modulator responses. The skilled person will appreciate that, whilst two waveforms having differing wavelengths cannot strictly be in or out of phase, a given phase relationship can be approximated across a desired range of operation (for example, by using two wavelengths which are close in value but not equal). Thus, it may be that the first wavelength and the second wavelength are chosen to approximate the desired phase relationship between the responses. It may be that the method comprises combining the input signal with a bias voltage. It may be that the modulating is performed on the basis of the combined bias and input signals. It may be that the method comprises adjusting the bias voltage in order to set the phase relationship between the modulator responses.

The optical system may comprise one or more (for example, all) of the optical combiner, the interferometric modulator, the wavelength dependent splitter, the first optical detector, and the second optical detector.

The method may further comprise combining the first laser pulse train and second laser pulse train. In such cases, it may be that the modulating is performed on the combined laser pulse train signal. It may be that the modulating comprises performing beam splitting to create two instances of the combined laser pulse train signal. It may be that the modulating comprises applying a time delay to one of the instances of the combined laser pulse train signal relative to the other instance. It may be that the applied time delay is determined on the basis of the analogue input signal. It may be that the modulating comprises recombining the two instances of the combined laser pulse train signal such that they interfere to produce a modulated combined laser pulse train signal.

It will be appreciated by the skilled person that the modulated combined laser pulse train signal comprises the superposition of the modulated first laser pulse train and the modulated second laser pulse train. Thus, the method may further comprise performing wavelength dependent splitting of the modulated combined laser pulse train signal to generate the modulated first laser pulse train and the modulated second laser pulse train. The method may further comprise operating a first optical detector to convert the modulated first laser pulse train into a first modulated analogue electrical signal. The method may further comprise operating a second optical detector to convert the modulated second laser pulse train into a second modulated analogue electrical signal. In such cases, the determining may be performed on the basis of the first modulated analogue electrical signal and the second modulated analogue electrical signal. The method may further comprise operating a first analogue-to-digital converter to convert the first modulated analogue electrical signal into a first digital bitstream. The method may further comprise operating a second analogue-to-digital converter to convert the second modulated analogue electrical signal into a second digital bitstream. In such cases, the determining may be performed on the basis of the first digital bitstream and the second digital bitstream.

Operating the first analogue-to-digital converter may comprises clocking the first analogue-to-digital converter at the pulse repetition rate of the first and second lasers. Operating the second analogue-to-digital converter may comprises clocking the second analogue-to-digital converter at the pulse repetition rate of the first and second lasers. It may be that the clocking of the first analogue-to-digital converter and/or the second analogue-to-digital converter is synchronised to the pulses in the first and/or second laser pulse trains.

The interferometric modulator may comprise a Mach Zehnder modulator. The interferometric modulator may have a substantially periodic response. The interferometric modulator may have a substantially sinusoidal response. The interferometric modulator may have a first response to a first wavelength (for example, that of the first laser pulse train) and a second different response to a second wavelength (for example, that of the second laser pulse train). The optical system may have a substantially periodic (for example, sinusoidal) response. The optical system may have a substantially sinusoidal response. The optical system may have a first response to a first wavelength (for example, that of the first laser pulse train) and a second different response to a second wavelength (for example, that of the second laser pulse train).

The method may comprise processing the first modulated analogue electrical signal. The method may comprise processing the second modulated analogue electrical signal. The processing of the first and/or second modulated analogue electrical signals may be such to make them more suitable for processing by the first and second analogue-to-digital converters. The processing may comprise spreading the first and/or second modulated analogue electrical signals in time. The processing may comprise low pass filtering the first and/or second modulated analogue electrical signals.

The method may comprise operating an optical network to generate a plurality of repeated pulses for each pulse in the first and/or second modulated laser pulse trains. It will be appreciated by the skilled person that generate a plurality of repeated pulses for each pulse in the first and/or second modulated laser pulse trains can assist in spreading those signals in time.

According to a second aspect of the invention there is also provided a computer program comprising instructions which, when the program is executed by a computing device, cause the computing device to carry out a method of performing analogue to digital conversion of an analogue input signal, the method comprising:
operating a first digitisation circuit to convert a first laser pulse train into a first digital bitstream, the first laser pulse train having a first wavelength and having been modulated on the basis of the analogue input signal using an interferometric modulator, the interferometric modulator having a first response to the first laser pulse train;
operating a second digitisation circuit to convert a second laser pulse train into a second digital bitstream, the second laser pulse train having a second wavelength and having been modulated on the basis of the analogue input signal using the interferometric modulator, the interferometric modulator having a second different response to the second laser pulse train;
determining, on the basis of the first digital bitstream and the second digital bitstream, a voltage of the analogue input signal; and
generating a digital signal indicative of the determined voltage.

According to a third aspect of the invention there is also provided a system for performing analogue to digital conversion of an analogue input signal, the system comprising:
a laser pulse generation module configured to generate a first laser pulse train having a first wavelength and a second laser pulse train having a second different wavelength;
an interferometric modulator configured to modulate the first laser pulse train and the second laser pulse train on the basis of the analogue input signal such that a response of the interferometric modulator to the first laser pulse train is not in phase with the response of the interferometric modulator to the second laser pulse train;
determining, on the basis of the modulated first laser pulse train and the modulated second laser pulse train, a voltage of the analogue input signal; and generating a digital signal indicative of the determined voltage.

It will of course be appreciated that features described in relation to one aspect of the present invention may be incorporated into other aspects of the present invention. For example, the method of the invention may incorporate any of the features described with reference to the apparatus of the invention and *vice versa.*

### Description of the Drawings

Embodiments of the present invention will now be described by way of example only with reference to the accompanying schematic drawings of which:
Figure 1 shows a schematic view of an analogue to digital converter according to a first embodiment of the invention;
Figure 2 shows a graph of the relationship between the input voltage to the analogue to digital converter and the output voltage from an optical detector of Figure 1;
Figure 3 shows a schematic view of an analogue to digital converter according to a second embodiment of the invention; and
Figure 4 shows a flow chart illustrating the steps of a method according to a third embodiment of the invention.

### Detailed Description

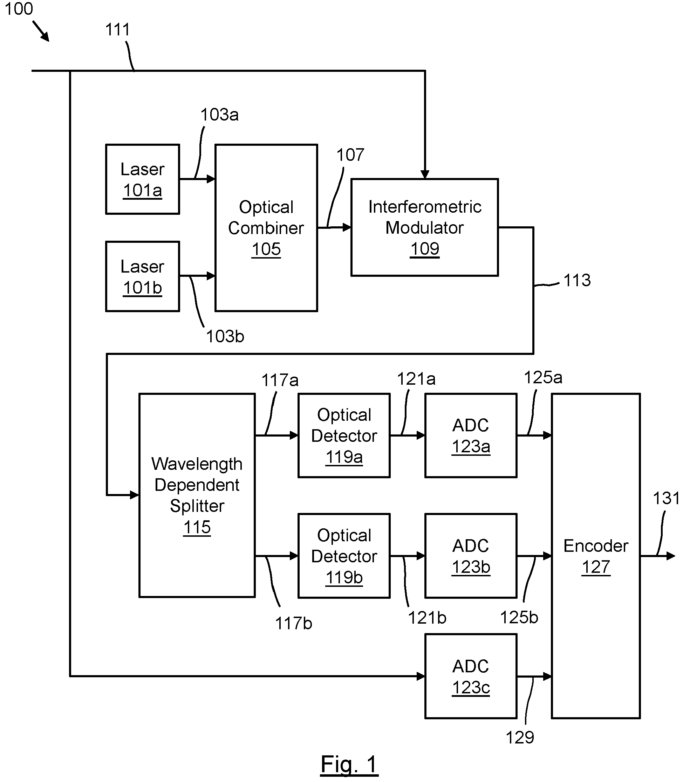

Figure 1 shows a schematic view of a system 100 for performing analogue to digital conversion of an analogue input signal according to a first embodiment of the invention.

The analogue-to-digital conversion system 100 comprises a first laser 101a and a second laser 101b. The first laser 101a is configured to generate a first laser pulse train 103a having a first wavelength. The second laser 101b is configured to generate a second laser pulse train 103b having a second wavelength. The second wavelength is different to the first wavelength.. The first laser pulse train 103a can be said to comprise a first plurality of laser pulses emitted at regular intervals according to a first pulse repetition rate. Similarly, the second laser pulse train 103b can be said to comprise a second plurality of laser pulses emitted at regular intervals according to a second pulse repetition rate. In this example embodiment, the first pulse repetition rate is the same as the second pulse repetition rate and the first laser pulse train is synchronised with the second laser pulse train.

The first laser pulse train 103a and the second laser pulse train 103b are input to an optical combiner 105. The optical combiner operates to combine the first laser pulse train 103a and the second laser pulse train 103b to form a combined laser pulse train signal 107. The combined laser pulse train signal 107 simply comprises the superposition of the first laser pulse train 103a and the second laser pulse train 103b. Thus, both the first laser pulse train 103a and the second laser pulse train 103b can be considered to be present within the combined laser pulse train signal 107.

The combined laser pulse train signal 107 is input to an interferometric modulator 109. The interferometric modulator 109 is operated, under the control of an analogue input signal 111 (i.e. the signal intended to undergo analogue-to-digital conversion), to modulate the combined laser pulse train signal 107. Thus, the interferometric modulator 109 is configured to modulate the first laser pulse train and the second laser pulse train on the basis of the analogue input signal 111. The interferometric modulator 109 is configured such that its response to the first laser pulse train 103a is not in phase with its response to the second laser pulse train 103b. In this example embodiment, the interferometric modulator 109 is configured such that its response to the first laser pulse train 103a is substantially in quadrature with its response to the second laser pulse train 103b.

In this example embodiment, the interferometric modulator 109 comprises a Mach-Zehnder modulator. However, it will be appreciated by the skilled person that other types of interferometric modulator may alternatively be used. Thus, the interferometric modulator 109 comprises two optical paths (not shown). The input combined laser pulse train signal 107 is split between the two paths and subsequently recombined. The relative optical phase (i.e. due to the difference in group delay) between the two paths is controlled according to the analogue input signal 111 to modulate the combined laser pulse train signal 107.

The interferometric modulator 109 is configured such that variation of the analogue input signal 111 gives rise to a phase shift of greater than a cycle of the wavelengths of one or both of the first laser pulse train and the second laser pulse train. Thus, the range of operation of the interferometric modulator 109 extends well beyond the pseudo-linear region of its periodic (for example, sinusoidal) response. In this example embodiment, the range of operation of the interferometric modulator 109 extends over multiple cycles of the periodic (for example, sinusoidal) response of the modulator.

The modulated combined laser pulse train signal 113 is input to a wavelength dependent splitter 115. Due to the different wavelengths of the first laser pulse train 103a and the second laser pulse train 103b, the wavelength dependent splitter 115 is capable of distinguishing between the associated components of the modulated combined laser pulse train signal 113. The wavelength dependent splitter 115 operates to split the signal into a modulated first laser pulse train 117a and a modulated second laser pulse train 117b.

As previously mentioned, both the first laser pulse train 103a and the second laser pulse train 103b can be considered to be present within the combined laser pulse train signal 107. Thus, each of the modulated first laser pulse train 117a and the modulated second laser pulse train 117b can be considered to have a respective modulation state, due to having been modulated by the interferometric modulator 109. Thus, the modulated first laser pulse train 117a has a first modulation state, associated with the modulation applied by the interferometric modulator 109 to the first laser pulse train 103a. Similarly, the modulated second laser pulse train 117b has a second modulation state, associated with the modulation applied by the interferometric modulator 109 to the second laser pulse train 103a.

It will be appreciated by the skilled person that, due to interferometric modulator 109 applying a phase shift of greater than a cycle of the wavelengths of one or both of the first laser pulse train 103a and the second laser pulse train 103b, a given combination of the first modulation state and the second modulation state is associated with a plurality of voltages of the analogue input signal 111.

The modulated first laser pulse train 117a is input to a first optical detector 119a. The first optical detector 119a operates to convert the modulated first laser pulse train 117a into a first modulated analogue electrical signal 121a. The modulated second laser pulse train 117b is input to a second optical detector 119b. The second optical detector 119b operates to convert the modulated second laser pulse train 117b into a second modulated analogue electrical signal 121b. In this example embodiment, both the first optical detector 119a and the second optical detector 119b each comprise a photodiode. However, it will be appreciated by the skilled person that other means for conversion of an optical signal to an analogue electrical signal may also be used.

It will be appreciated by the skilled person that the first optical detector 119a and the second optical detector 119b are the final stages in the optical system of the analogue-to-digital conversion system 100. Thus, the first modulated analogue electrical signal 121a and the second modulated analogue electrical signal 121b comprise outputs from the optical system.

The first modulated analogue electrical signal 121a is input to a first analogue-to-digital converter 123a. The first analogue-to-digital converter 123a operates to convert the first modulated analogue electrical signal 121a into a first digital bitstream 125a. The second modulated analogue electrical signal 121b is input to a second analogue-to-digital converter 123b. The second analogue-to-digital converter 123b operates to convert the second modulated analogue electrical signal 121b into a second digital bitstream 125b. Both the first analogue-to-digital converter 123a and the second analogue-to-digital converter 123b are clocked at the pulse rate of the first and second lasers 101a, 101b (i.e. at the pulse repetition rate).

In this example embodiment, the analogue-to-digital conversion system 100 further comprises a third analogue-to-digital converter 123c. The third analogue-to-digital converter 123c receives as an input the analogue input signal 111 and operates to convert the analogue input signal 111 into a digitised input signal 129. The third analogue-to-digital converter 123c is clocked at the pulse rate of the first and second lasers 101a, 101b (i.e. at the pulse repetition rate).

The first digital bitstream 125a, the second digital bitstream 125b, and the digitised input signal 129 are input to an encoder 127. The encoder 127 operates to determine, on the basis of the first digital bitstream 125a, the second digital bitstream 125b, and the digitised input signal 129, a voltage of the analogue input signal 111.

As previously mentioned, due to interferometric modulator 109 applying a phase shift of greater than a cycle of the wavelengths of one or both of the first laser pulse train 103a and the second laser pulse train 103b, a given combination of the first modulation state and the second modulation state is associated with a plurality of possible voltages of the analogue input signal 111. Thus, the encoder is configured to evaluate the first modulation state and the second modulation state to identify a plurality of possible voltage of the analogue input signal 111.

The encoder 127 is further configured to identify the particular voltage in the plurality of possible voltages which has caused the first modulation state and the second modulation state. In this example embodiment, the encoder 127 is configured to identify the particular voltage which has caused the first modulation state and the second modulation state by evaluating the digitised input signal 129. In this example, the encoder 127 is configured to perform the identification by determining which of the plurality of possible voltages which is closest to the voltage indicated by the digitised input signal 129. However, it will be appreciated by the skilled person that other means for identifying the particular voltage which has caused the first modulation state and the second modulation state may also be used.

The encoder 127 is further configured to generate a digital signal 131 indicative of the determined voltage.

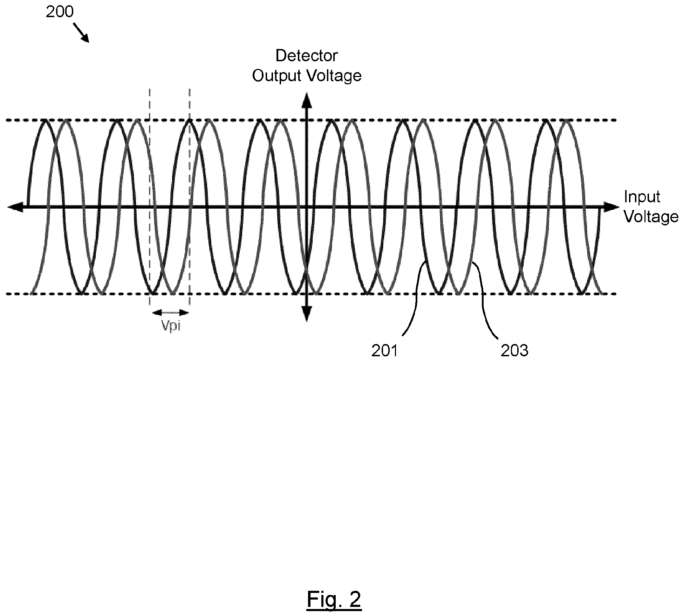

Figure 2 shows a graph 200 of the relationship between the voltage of the analogue input signal 111 and the output voltages from the optical detectors 119a, 119b. Trace 201 shows variation of the output voltage from the first optical detector 119a which occurs as the analogue input signal 111 varies. Trace 203 shows the variation of the output voltage from the second optical detector 119b which occurs as the analogue input signal 111 varies. The output voltage responses 201, 203 each have a sinusoidal relationship to the input voltage, but are displaced in phase relative to one another. In this example embodiment, the output voltage responses are substantially in quadrature. It can be seen that this maximises the difference in input voltage between points of inflection in output voltages 201, 203, which, as mentioned previously, minimises loss of sensitivity over the range of operation of the analogue-to-digital conversion system 100.

It can also be seen from the graph 200 that, where the operating range of the analogue-to-digital conversion system 100 extends over a plurality of cycles of the sinusoidal responses, each possible combination of the output voltages 201, 203 is produced multiple times at different values of the analogue input signal 111. Thus, a given combination of the first and second modulation states is associated with more than one voltage of the analogue input signal 111.

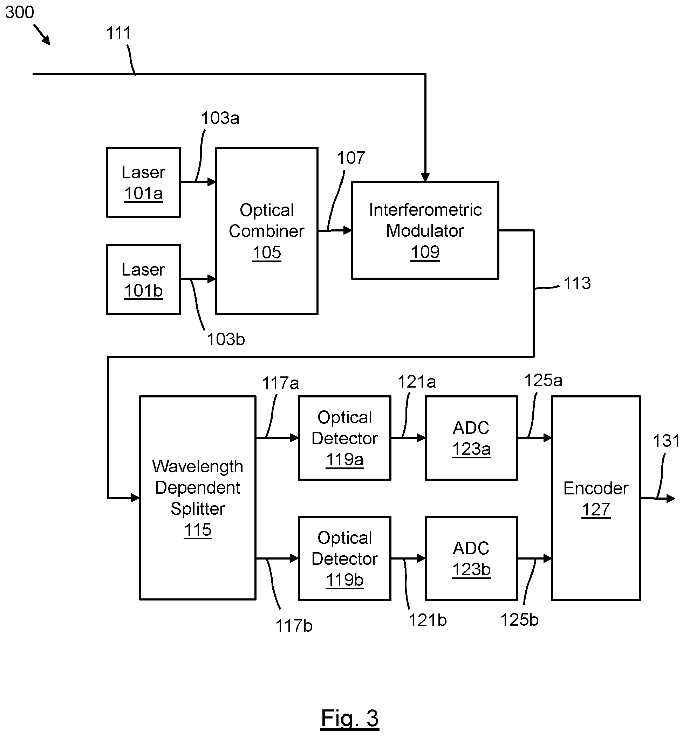

Figure 3 shows a schematic view of an analogue-to-digital conversion system 300 according to a second embodiment of the invention. The analogue-to-digital conversion system 300 of the second embodiment is substantially identical to analogue-to-digital conversion system 100 of the first embodiment except for the following differences.

The analogue-to-digital conversion system 300 of the second embodiment does not include the third analogue-to-digital converter 123c. The encoder 127 is therefore not configured to identify which particular voltage in the plurality of possible voltages has given rise to the first modulation state and the second modulation state on the basis of digitised input signal 129. Instead, the encoder 127 is configured to store (for example, in a memory) a most recently determined voltage of the analogue input signal 111. The encoder is configured to identify the particular voltage which has given rise to the first modulation state and the second modulation state on the basis of stored voltage. In this example embodiment, the encoder 127 is configured to perform the identification by identifying which of the plurality of possible voltages is closest to the most recently determined stored voltage. It will be appreciated that, in other embodiments, the encoder may be configured to store a plurality of previously determined voltages and may perform the identification based on more than one voltage in the plurality (for example, by identifying which of the plurality of possible voltages is closest to an average of the stored plurality of voltages).

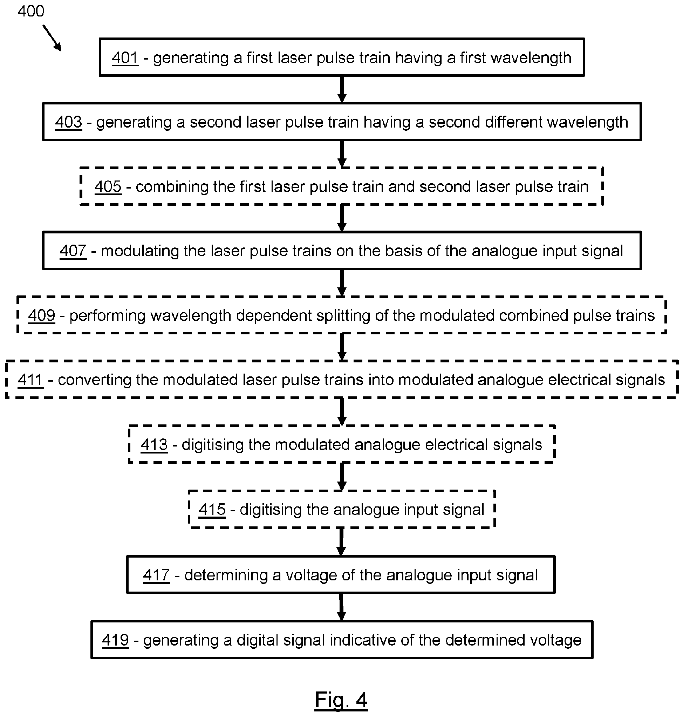

Figure 4 shows a flow chart illustrating the steps of a method 400 of performing analogue to digital conversion of an analogue input signal according to a third embodiment of the invention.

A first step of method 400, represented by item 401, comprises generating a first laser pulse train having a first wavelength.

A second step of method 400, represented by item 403, comprises generating a second laser pulse train having a second different wavelength.

An optional third step of method 400, represented by item 405, comprises combining the first laser pulse train and second laser pulse train.

A fourth step of method 400, represented by item 407, comprises modulating, using an interferometric modulator, the first laser pulse train and the second laser pulse train on the basis of the analogue input signal, wherein the interferometric modulator is configured such that its response to the first laser pulse train is not in phase with its response to the second laser pulse train. It may be that the modulating is performed on the combined laser pulse trains.

It may be that the modulating comprises operating the interferometric modulator such that variation of the analogue input signal gives rise to a phase shift of greater than half a cycle of the wavelengths of one or both of the first laser pulse train and the second laser pulse train. It may be that the variation gives rise to a phase shift of greater than one cycle of the wavelengths.

It may be that the modulated first laser pulse train has a first modulation state, associated with the modulation applied to the first laser pulse train, and the modulated second laser pulse train has a second modulation state, associated with the modulation applied to the second laser pulse train. In such cases, it may be that at least one combination of the first modulation state and the second modulation state is associated with a plurality of voltages of the analogue input signal.

It may be that the method 400 comprises configuring the interferometric modulator such that its response to the first laser pulse train is substantially in quadrature with its response to the second laser pulse train.

The interferometric modulator may comprise a Mach Zehnder modulator.

An optional fifth step of method 400, represented by item 409 comprises performing wavelength dependent splitting of the modulated combined pulse trains to generate the modulated first laser pulse train and the modulated second laser pulse train.

An optional sixth step of method 400, represented by item 411 comprises operating a first optical detector to convert the modulated first laser pulse train into a first modulated analogue electrical signal and operating a second optical detector to convert the modulated second laser pulse train into a second modulated analogue electrical signal.

An optional seventh step of method 400, represented by item 413 comprises operating a first analogue to digital converter to convert the first modulated analogue electrical signal into a first digital bitstream and operating a second analogue to digital converter to convert the second modulated analogue electrical signal into a second digital bitstream.

An optional eighth step of method 400, represented by item 415, comprises operating an analogue to digital converter to convert the analogue input signal into a digitised input signal.

A ninth step of method 400, represented by item 417, comprises determining, on the basis of the modulated first laser pulse train and the modulated second laser pulse train, a voltage of the analogue input signal.

In embodiments in which the modulated first laser pulse train has a first modulation state, associated with the modulation applied to the first laser pulse train, and the modulated second laser pulse train has a second modulation state, associated with the modulation applied to the second laser pulse train, it may be that the determining comprises evaluating the first modulation state and the second modulation state. In embodiments in which at least one combination of the first modulation state and the second modulation state is associated with a plurality of voltages of the analogue input signal, the determining may comprise identifying a voltage in the plurality which has caused the first modulation state and the second modulation state.

It may be that the determining is performed on the basis of the first digital bitstream and the second digital bitstream. It may be that the identifying is performed on the basis of one or more previously determined voltages of the analogue input signal. It may be that the identifying is performed on the basis of the digitised input signal.

A tenth step of method 400, represented by item 419, comprises generating a digital signal indicative of the determined voltage.

Whilst the present invention has been described and illustrated with reference to particular embodiments, it will be appreciated by those of ordinary skill in the art that the invention lends itself to many different variations not specifically illustrated herein. By way of example only, certain possible variations will now be described.

Whilst in the illustrated embodiments, the interferometric modulator comprises a Mach Zehnder modulator, it will be appreciated by the skilled person that, in other embodiments, other types of modulator could alternatively be used.

Whilst the illustrated embodiments show two method for identifying which of the plurality of possible voltages has given rise to a given combination of the first modulation state and the second modulation state (namely: (i) by directly evaluating the voltage of the input signal, and (ii) by evaluating one or more previously determined voltages of the input signal), it will be appreciated by the skilled person that other means for performing the identification are also possible. For example, in other embodiments, the first wavelength and the second wavelength may be such that, over the intended operating range of the analogue-to-digital converter, the first pulse train and the second pulse train are associated with different cosine repeat rates. In such cases, it may be that the encoder is configured to perform the identification solely on the basis of the first digital bitstream and the second digital bitstream.

It will be appreciated that, whilst the illustrated embodiments include a first laser and a second laser, in other embodiments only one laser is required. In such embodiments, it may be that the first laser pulse train and the second laser pulse train are generated by use of the single laser.

Whilst the illustrated embodiments comprise two lasers, it will be appreciated by the skilled person that other embodiments of the invention may comprise more than two lasers. For example, the method may comprise generating a third laser pulse train. In such cases, it may be that the responses of the interferometric modulator to each of the three laser pulse trains are arranged to be substantially spread at 120° intervals.

Whilst not discussed in detail above, it will be appreciated by the skilled person that, in some embodiments, the analogue-to-digital conversion system of the present invention may require one or more calibration steps (for example, to adjust for minor timing errors or variations in the phase relationship between the modulator responses to the laser pulse trains). Such calibration steps may comprise injecting a test signal into the analogue-to-digital conversion system. The calibration may comprise adjusting one or more components of the system (for example, wavelengths of one or both of the first and second lasers) on the basis of test signal. The calibration may comprise operating the encoder to compensate for a measured error or variation (for example, by applying a delay to the digital signals from one or more of the ADCs).

It will be appreciated that the encoder 127 may comprise one or more processors and/or memory. The processor and associated memory may be configured to perform one or more of the above-described functions of the encoder 127. One or more aspects of the embodiments described herein comprise processes performed by apparatus. In some examples, the apparatus comprises one or more processors configured to carry out these processes. In this regard, embodiments may be implemented at least in part by computer software stored in (non-transitory) memory and executable by the processor, or by hardware, or by a combination of tangibly stored software and hardware (and tangibly stored firmware). Embodiments also include computer programs, particularly computer programs on or in a carrier, adapted for putting the above-described embodiments into practice. The program may be in the form of non-transitory source code, object code, or in any other non-transitory form suitable for use in the implementation of processes according to embodiments. The carrier may be any entity or device capable of carrying the program, such as a RAM, a ROM, or an optical memory device, etc.

The one or more processors of the encoder 127 may comprise a central processing unit (CPU). The one or more processors may comprise a graphics processing unit (GPU). The one or more processors may comprise one or more of a field programmable gate array (FPGA), a programmable logic device (PLD), or a complex programmable logic device (CPLD). The one or more processors may comprise an application specific integrated circuit (ASIC). It will be appreciated by the skilled person that many other types of device, in addition to the examples provided, may be used to provide the one or more processors. The one or more processors may comprise multiple co-located processors or multiple disparately located processors. Operations performed by the one or more processors may be carried out by one or more of hardware, firmware, and software.

The one or more processors may comprise data storage. The data storage may comprise one or both of volatile and non-volatile memory. The data storage may comprise one or more of random access memory (RAM), read-only memory (ROM), a magnetic or optical disk and disk drive, or a solid-state drive (SSD). It will be appreciated by the skilled person that many other types of memory, in addition to the examples provided, may also be used. It will be appreciated by a person skilled in the art that the one or more processors may each comprise more, fewer and/or different components from those described.

The techniques described herein may be implemented in software or hardware, or may be implemented using a combination of software and hardware. They may include configuring an apparatus to carry out and/or support any or all of techniques described herein. Although at least some aspects of the examples described herein with reference to the drawings comprise computer processes performed in processing systems or processors, examples described herein also extend to computer programs, for example computer programs on or in a carrier, adapted for putting the examples into practice. The carrier may be any entity or device capable of carrying the program. The carrier may comprise a computer readable storage media. Examples of tangible computer-readable storage media include, but are not limited to, an optical medium (e.g., CD-ROM, DVD-ROM or Blu-ray), flash memory card, floppy or hard disk or any other medium capable of storing computer-readable instructions such as firmware or microcode in at least one ROM or RAM or Programmable ROM (PROM) chips.

Where in the foregoing description, integers or elements are mentioned which have known, obvious or foreseeable equivalents, then such equivalents are herein incorporated as if individually set forth. Reference should be made to the claims for determining the true scope of the present invention, which should be construed so as to encompass any such equivalents. It will also be appreciated by the reader that integers or features of the invention that are described as preferable, advantageous, convenient or the like are optional and do not limit the scope of the independent claims. Moreover, it is to be understood that such optional integers or features, whilst of possible benefit in some embodiments of the invention, may not be desirable, and may therefore be absent, in other embodiments.

## Claims

1. A method of performing analogue to digital conversion of an analogue input signal, the method comprising:
generating a first laser pulse train having a first wavelength;
generating a second laser pulse train having a second different wavelength;
modulating, using an interferometric modulator, the first laser pulse train and the second laser pulse train on the basis of the analogue input signal, wherein the interferometric modulator is configured such that its response to the first laser pulse train is not in phase with its response to the second laser pulse train;
determining, on the basis of the modulated first laser pulse train and the modulated second laser pulse train, a voltage of the analogue input signal; and
generating a digital signal indicative of the determined voltage.

2. A method according to claim 1, wherein the modulating comprises operating the interferometric modulator such that variation of the analogue input signal gives rise to a phase shift of greater than half a cycle of one or both of the first wavelength and the second wavelength.

3. A method according to claim 2, wherein the variation gives rise to a phase shift of greater than one cycle of one or both of the first wavelength and the second wavelength.

4. A method according to claim 3, wherein:
the modulated first laser pulse train has a first modulation state, associated with the modulation applied to the first laser pulse train, and the modulated second laser pulse train has a second modulation state, associated with the modulation applied to the second laser pulse train; and
the determining comprises evaluating the first modulation state and the second modulation state.

5. A method according to claim 4, wherein at least one combination of the first modulation state and the second modulation state is associated with a plurality of voltages of the analogue input signal.

6. A method according to claim 5, wherein the determining comprises identifying a voltage in the plurality which has caused the first modulation state and the second modulation state.

7. A method according to claim 6, wherein the identifying is performed on the basis of one or more previously determined voltages of the analogue input signal.

8. A method according to claim 6, wherein:
the method further comprises operating an analogue to digital converter to convert the analogue input signal into a digitised input signal; and
the identifying is performed on the basis of the digitised input signal.

9. A method according to any preceding claim, wherein the interferometric modulator is configured such that its response to the first laser pulse train is substantially in quadrature with its response to the second laser pulse train.

10. A method according to any preceding claim, wherein:
the method further comprises combining the first laser pulse train and second laser pulse train; and
the modulating is performed on the combined laser pulse trains;

11. A method according to claim 10, further comprising performing wavelength dependent splitting of the modulated combined pulse trains to generate the modulated first laser pulse train and the modulated second laser pulse train.

12. A method according to any preceding claim, further comprising:
operating a first optical detector to convert the modulated first laser pulse train into a first modulated analogue electrical signal; and
operating a second optical detector to convert the modulated second laser pulse train into a second modulated analogue electrical signal.

13. A method according to claim 12, further comprising:
operating a first analogue to digital converter to convert the first modulated analogue electrical signal into a first digital bitstream; and
operating a second analogue to digital converter to convert the second modulated analogue electrical signal into a second digital bitstream.

14. A method according to claim 13, wherein the determining is performed on the basis of the first digital bitstream and the second digital bitstream.

15. A method according to any preceding claim, wherein the interferometric modulator comprises a Mach Zehnder modulator.

16. A computer program comprising instructions which, when the program is executed by a computing device, cause the computing device to carry out a method of performing analogue to digital conversion of an analogue input signal, the method comprising:
operating a first digitisation circuit to convert a first laser pulse train into a first digital bitstream, the first laser pulse train having a first wavelength and having been modulated on the basis of the analogue input signal using an interferometric modulator, the interferometric modulator having a first response to the first laser pulse train;
operating a second digitisation circuit to convert a second laser pulse train into a second digital bitstream, the second laser pulse train having a second wavelength and having been modulated on the basis of the analogue input signal using the interferometric modulator, the interferometric modulator having a second different response to the second laser pulse train;
determining, on the basis of the first digital bitstream and the second digital bitstream, a voltage of the analogue input signal; and
generating a digital signal indicative of the determined voltage.

17. A system for performing analogue to digital conversion of an analogue input signal, the system comprising:
a laser pulse generation module configured to generate a first laser pulse train having a first wavelength and a second laser pulse train having a second different wavelength;
an interferometric modulator configured to modulate the first laser pulse train and the second laser pulse train on the basis of the analogue input signal such that a response of the interferometric modulator to the first laser pulse train is not in phase with the response of the interferometric modulator to the second laser pulse train;
determining, on the basis of the modulated first laser pulse train and the modulated second laser pulse train, a voltage of the analogue input signal; and
generating a digital signal indicative of the determined voltage.
